# EUROPEAN PATENT APPLICATION

(11) **EP 4 804 164 A1**
(43) Date of publication of application: **09.09.2026**
(21) Application number: 25833856.5
(22) Date of filing: 26.09.2025
(51) Int. Cl.: G09B 23/18

(54) **BATTERY VOLTAGE SIMULATION CIRCUIT AND SYSTEM, AND POWER BATTERY PRACTICAL TRAINING DEVICE**

(30) Priority: 23.12.2024 CN 202423183247 U
(71) Applicant: Contemporary Amperex Technology Co., Limited, Ningde, Fujian 352100 (CN)
(72) Inventor: KONG, Chunfang, Ningde, Fujian 352100 (CN)
(74) Representative: Kraus & Lederer PartGmbB
(86) International application number: PCT/CN2025/124533
(87) International publication number: WO 2026/138041

(57) **Abstract**

The present application discloses a battery voltage simulation circuit, a battery voltage simulation system, and a power battery training apparatus, including: an isolation connection unit, a control unit, and a conversion output unit; an input end of the isolation connection unit is configured to be electrically connected to an external input device, an output end of the isolation connection unit is electrically connected to an input end of the control unit, an output end of the control unit is electrically connected to an input end of the conversion output unit, and an output end of the conversion output unit is configured to be electrically connected to a simulated battery cell; the isolation connection unit electrically isolates the control unit from the external input device and receives a required voltage signal transmitted by the external input device; the control unit is configured to respond to the required voltage signal by outputting a pulse modulation signal with a target duty cycle to the conversion output unit, where pulse modulation signals corresponding to different required voltage signals have different duty cycles; the conversion output unit converts the pulse modulation signal with the target duty cycle into a corresponding voltage simulation signal, enabling the simulated battery cell to simulate the output of the voltage.

## Description

### CROSS-REFERENCE TO RELATED APPLICATIONS

The present application claims the priority of Chinese Patent Application No. 202423183247.X, filed on December 23, 2024, entitled "BATTERY VOLTAGE SIMULATION CIRCUIT, BATTERY VOLTAGE SIMULATION SYSTEM AND POWER BATTERY TRAINING APPARATUS INCLUDING SAME," which is incorporated herein by reference in its entirety.

### TECHNICAL FIELD

The present application relates to the field of battery technologies, and specifically to a battery voltage simulation circuit, a battery voltage simulation system and a power battery training apparatus including the same.

### BACKGROUND ART

Batteries, as a common power source, are used in numerous experiments (for example, as training apparatuses). If a battery prototype is used directly for research, the acquisition and maintenance of battery prototypes require significant costs; and in addition, conducting experiments under extreme operating conditions may cause damage to the prototype. Therefore, circuits that simulate battery voltage output are commonly used to accurately simulate output characteristics of batteries, thereby replacing actual batteries in experiments. This approach can address the above issues, significantly reducing research costs and accelerating research progress.

However, most commonly used battery voltage simulation circuits can only simulate and output the battery voltage required for actual use and cannot adjust the simulated voltage to achieve a practical training effect of simulating battery faults.

### SUMMARY OF THE INVENTION

In view of the above issues, the present application provides a battery voltage simulation circuit, a battery voltage simulation system and a power battery training apparatus including the same, so as to address the issue that conventional battery voltage simulation circuits can only simulate and output the battery voltage required for actual use and cannot adjust the simulated voltage to achieve a training effect of simulating battery faults.

In a first aspect, the present application provides a battery voltage simulation circuit, including: an isolation connection unit, a control unit, and a conversion output unit; where an input end of the isolation connection unit is configured to be electrically connected to an external input device, an output end of the isolation connection unit is electrically connected to an input end of the control unit, an output end of the control unit is electrically connected to an input end of the conversion output unit, and an output end of the conversion output unit is configured to be electrically connected to a simulated battery cell; the isolation connection unit is configured to electrically isolate the control unit from the external input device and receive a required voltage signal transmitted by the external input device, transmitting the required voltage signal to the control unit; the control unit is configured to respond to the required voltage signal by outputting a pulse modulation signal with a target duty cycle to the conversion output unit, where pulse modulation signals corresponding to different required voltage signals have different duty cycles; and the conversion output unit is configured to convert the pulse modulation signal with the target duty cycle into a corresponding voltage simulation signal, enabling the simulated battery cell to simulate the output of the required voltage.

In the battery voltage simulation circuit designed as described above, the control unit stores the association between different required voltage signals and corresponding duty cycles. Thus, upon receiving different required voltage signals, the control unit can output a pulse modulation signal with a duty cycle corresponding to the required voltage based on the required voltage signal, so that after digital-to-analog conversion of the pulse modulation signal, the output of the simulated battery voltage output is implemented. Then, with the use of pulse modulation signals with different duty cycles, the adjustment of different simulated battery voltages can be implemented, enabling high-precision simulation and adjustment of battery voltage to meet application scenarios with high voltage precision requirements, such as teaching experiments.

In some embodiments, the isolation connection unit includes a communication component and an isolation drive component; where an input end of the communication component is configured to be electrically connected to the external input device, an output end of the communication component is electrically connected to an input end of the isolation drive component, and an output end of the isolation drive component is electrically connected to the control unit; the communication component is configured to forward the required voltage signal transmitted by the external input device to the isolation drive component; and the isolation drive component is configured to electrically isolate the control unit from the external input device and transmit the required voltage signal to the control unit.

With the above implementation, the design of the isolation connection unit in this solution effectively isolates the external input device from the control unit, preventing external interference from affecting the internal circuit, thereby improving the stability and reliability of the entire circuit system and reducing the possibility of voltage simulation errors and circuit failures due to external interference.

In some embodiments, the conversion output unit includes at least one digital-to-analog conversion group, where each digital-to-analog conversion group includes one digital-to-analog converter and one operational amplifier, an input end of the digital-to-analog converter of each digital-to-analog conversion group is electrically connected to the output end of the control unit, an output end of the digital-to-analog converter of each digital-to-analog conversion group is connected to an input end of the operational amplifier of the corresponding digital-to-analog conversion group, and an output end of each operational amplifier is configured to be electrically connected to one simulated battery cell; the digital-to-analog converter is configured to convert the pulse modulation signal with the target duty cycle into a corresponding voltage simulation signal and transmit it to the operational amplifier; the operational amplifier is configured to amplify the voltage simulation signal and output it, enabling the corresponding connected simulated battery cell to output the required voltage.

In some embodiments, one or more digital-to-analog conversion groups are provided.

With the above implementation, the control unit designed in this solution can connect to multiple digital-to-analog conversion groups simultaneously, enabling the control unit to simulate and adjust voltages of multiple simulated battery cells at once. Consequently, under the condition of performing voltage simulation for multiple simulated battery cells, the arrangement space of components is reduced, thereby saving component resources and costs.

In some embodiments, the battery voltage simulation circuit further includes a power supply unit; where the power supply unit is electrically connected to the isolation connection unit and the control unit, respectively, to supply power to the isolation connection unit and the control unit.

In some embodiments, the power supply unit includes a power source and a voltage reduction component; where the power source is electrically connected to the isolation connection unit and the control unit through the voltage reduction component; the voltage reduction component is configured to reduce a supply voltage of the power source to a first supply voltage and a second supply voltage; where the first supply voltage is used to supply power to the isolation connection unit, and the second supply voltage is used to supply power to the control unit.

With the above implementation, the voltage reduction component in this solution is used to reduce the supply voltage of the power source to the normal operating voltages of the isolation connection unit and the control unit, thereby ensuring their normal operation and preventing high voltages from compromising the service life of the isolation connection unit and the control unit.

In some embodiments, the voltage reduction component includes a voltage reduction module and an isolation power module; where an input end of the voltage reduction module is electrically connected to the power source, and an output end of the voltage reduction module is electrically connected to the isolation connection unit and the control unit through the isolation power module; the voltage reduction module is configured to reduce a supply voltage of the power source to the first supply voltage and the second supply voltage and transmit the first supply voltage and the second supply voltage to the isolation power module; and the isolation power module is configured to transmit the first supply voltage to the isolation connection unit, transmit the second supply voltage to the control unit, and electrically isolate the isolation connection unit and the control unit from the power source.

With the above implementation, the isolation power module in this solution is used to achieve electrical isolation of the power source, ensuring that the battery voltage simulation circuit does not experience issues with excessive or insufficient supply current, thereby improving the safety of operating the battery voltage simulation circuit.

In a second aspect, the present application provides a battery voltage simulation system, including the battery voltage simulation circuit described in any optional implementation of the first aspect, an external input device, and a simulated battery cell; where an input end of the isolation connection unit is electrically connected to the external input device, and the conversion output unit is electrically connected to the simulated battery cell.

The battery voltage simulation system designed as described above includes the battery voltage simulation circuit described above. Therefore, the designed battery voltage simulation system can store the association between different required voltage signals and corresponding duty cycles in the control unit. Thus, upon receiving different required voltage signals, the control unit can output a pulse modulation signal with a duty cycle corresponding to the required voltage based on the required voltage signal, so that after digital-to-analog conversion of the pulse modulation signal, the output of the simulated battery voltage output is implemented. Then, with the use of pulse modulation signals with different duty cycles, the adjustment of different simulated battery voltages can be implemented, enabling high-precision simulation and adjustment of battery voltage to meet application scenarios with high voltage precision requirements, such as teaching experiments. In addition, the design of the isolation connection unit in this solution effectively isolates the external input device from the control unit, preventing external interference from affecting the internal circuit, thereby improving the stability and reliability of the entire circuit system and reducing the possibility of voltage simulation errors and circuit failures due to external interference.

In some embodiments, multiple battery voltage simulation circuits are provided, the battery voltage simulation system further includes a communication bus, and the external input device is electrically connected to the isolation connection unit of each battery voltage simulation circuit through the communication bus.

With the above implementation, the battery voltage simulation system designed in this solution connects multiple battery voltage simulation circuits through the communication bus, facilitating expansion of the number of simulated battery cells to meet the simulation needs of battery packs of different scales. The system can be applied to both small-scale laboratory tests and large-scale industrial development and research projects.

In a third aspect, the present application provides a power battery training apparatus, including the battery voltage simulation system described in any optional embodiment of the second aspect.

The power battery training apparatus designed as described above includes the battery voltage simulation system described above. Therefore, the designed power battery training apparatus can store the association between different required voltage signals and corresponding duty cycles in the control unit. Thus, upon receiving different required voltage signals, the control unit can output a pulse modulation signal with a duty cycle corresponding to the required voltage based on the required voltage signal, so that after digital-to-analog conversion of the pulse modulation signal, the output of the simulated battery voltage output is implemented. Then, with the use of pulse modulation signals with different duty cycles, the adjustment of different simulated battery voltages can be implemented, enabling high-precision simulation and adjustment of battery voltage to meet application scenarios with high voltage precision requirements, such as teaching experiments. In addition, the design of the isolation connection unit in this solution effectively isolates the external input device from the control unit, preventing external interference from affecting the internal circuit, thereby improving the stability and reliability of the entire circuit system and reducing the possibility of voltage simulation errors and circuit failures due to external interference.

The above description is only an overview of the technical solutions of the present application. In order to more clearly understand the technical means of the present application to implement same according to the content of the specification, and in order to make the above and other objectives, features, and advantages of the present application more obvious and understandable, specific embodiments of the present application are provided below.

### DESCRIPTION OF THE DRAWINGS

By reading the detailed description of the preferred embodiments below, various other advantages and benefits will become apparent to those of ordinary skill in the art. The drawings are provided solely to illustrate the preferred embodiments and are not considered to limit the present application. Throughout the drawings, identical components are denoted by identical reference numerals. In the drawings:
FIG. 1 is a first schematic circuit diagram of a battery voltage simulation circuit according to an embodiment of the present application;
FIG. 2 is a second schematic circuit diagram of a battery voltage simulation circuit according to an embodiment of the present application;
FIG. 3 is a third schematic circuit diagram of a battery voltage simulation circuit according to an embodiment of the present application;
FIG. 4 is a fourth schematic circuit diagram of a battery voltage simulation circuit according to an embodiment of the present application;
FIG. 5 is a fifth schematic circuit diagram of a battery voltage simulation circuit according to an embodiment of the present application;
FIG. 6 is a sixth schematic circuit diagram of a battery voltage simulation circuit according to an embodiment of the present application;
FIG. 7 is a schematic circuit diagram of an isolation power module according to an embodiment of the present application;
FIG. 8 is a first schematic circuit diagram of a battery voltage simulation system according to an embodiment of the present application;
FIG. 9 is a second schematic circuit diagram of a battery voltage simulation system according to an embodiment of the present application.

Reference numerals: A - external input device; B - simulated battery cell; C - communication bus; 1 - battery voltage simulation circuit; 10 - isolation connection unit; 110 - communication component; 120 - isolation drive component; 20 - control unit; 30 - conversion output unit; 310 - digital-to-analog conversion group; 3110 - digital-to-analog converter; 3120 - operational amplifier; 40 - power supply unit; 410 - power source; 420 - voltage reduction component; 4210 - voltage reduction module; and 4220 - isolation power module.

### DETAILED DESCRIPTION

The embodiments of the technical solutions of the present application will be described in detail below with reference to the accompanying drawings. The following embodiments are only used to illustrate the technical solutions of the present application more clearly and are merely examples, not intended to limit the scope of protection of the present application.

Unless otherwise defined, all technical and scientific terms used herein have the same meaning as commonly understood by those skilled in the technical field of the present application; the terms used herein are only for the purpose of describing specific embodiments and are not intended to limit the present application; the terms "including" and "having" and any variations thereof in the specification, claims, and the above description of the drawings of the present application are intended to cover non-exclusive inclusion.

In the description of the embodiments of the present application, technical terms such as "first" and "second" are used only to distinguish different objects and should not be understood as indicating or implying relative importance or implying the number, specific order, or primary-secondary relationship of the indicated technical features. In the description of the embodiments of the present application, the meaning of "multiple" is two or more, unless otherwise explicitly specified.

Reference to an "embodiment" herein means that a particular feature, structure, or characteristic described in connection with the embodiment may be included in at least one embodiment of the present application. The appearance of the phrase in various places in the specification does not necessarily refer to the same embodiment, nor is it an independent or alternative embodiment mutually exclusive with other embodiments. Those skilled in the art explicitly and implicitly understand that the embodiments described herein can be combined with other embodiments.

In the description of the embodiments of the present application, the term "and/or" merely describes an association relationship between associated objects, indicating that three relationships may exist, for example, A and/or B may indicate: A alone, both A and B, and B alone. Additionally, the character "/" herein generally indicates an "or" relationship between the associated objects.

In the description of the embodiments of the present application, the term "multiple" refers to two or more (including two), similarly, "multiple groups" refers to two or more groups (including two groups), and "multiple pieces" refers to two or more pieces (including two pieces).

In the description of the embodiments of the present application, technical terms such as "center," "longitudinal," "transverse," "length," "width," "thickness," "upper," "lower," "front," "rear," "left," "right," "vertical," "horizontal," "top," "bottom," "inner," "outer," "clockwise," "counterclockwise," "axial," "radial," and "circumferential" indicate orientations or positional relationships based on the orientations or positional relationships shown in the drawings, and are only for the convenience of describing the embodiments of the present application and simplifying the description, rather than indicating or implying that the referred device or element must have a specific orientation, be constructed and operated in a specific orientation, and thus cannot be understood as limiting the embodiments of the present application.

In the description of the embodiments of the present application, unless otherwise explicitly specified and limited, technical terms such as "install," "connect," "connection," and "fix" should be understood in a broad sense, for example, they may refer to fixed connections, detachable connections, or integral formations; they may be mechanical connections or electrical connections; they may be direct connections or indirect connections through an intermediate medium, or they may be internal communication between two elements or interaction relationships between two elements. Those of ordinary skill in the art can understand the specific meanings of the above terms in the embodiments of the present application based on specific circumstances.

Batteries, as a common power source, are used in numerous experiments (for example, as training apparatuses). If actual battery prototypes are used directly for research, on one hand, the acquisition and maintenance of battery prototypes require significant costs; on the other hand, experiments under extreme conditions may pose a risk of damage. Therefore, circuits that simulate battery voltage output are commonly used to accurately mimic the output characteristics of batteries, thereby replacing actual batteries in experiments. This approach can address the above issues, significantly reducing research costs and accelerating research progress.

However, most commonly used battery voltage simulation circuits can only output the voltage required by the actual battery and are unable to adjust the simulated voltage to achieve the training effect of simulating battery faults.

Based on the above problems, the present application designs a battery voltage simulation circuit, a battery voltage simulation system and a power battery training apparatus including the same. The control unit stores the association between different required voltage signals and corresponding duty cycles. Thus, upon receiving different required voltage signals, the control unit can output a pulse modulation signal with a duty cycle corresponding to the required voltage based on the required voltage signal, so that after digital-to-analog conversion of the pulse modulation signal, the output of the simulated battery voltage output is implemented. Then, with the use of pulse modulation signals with different duty cycles, the adjustment of different simulated battery voltages can be implemented, enabling high-precision simulation and adjustment of battery voltage to meet application scenarios with high voltage precision requirements, such as precision battery testing equipment and high-end teaching experiments. In addition, this solution further enables connection between the control unit and external devices through the isolation connection unit while providing electrical isolation, and achieves electrical isolation of the power supply through the isolation power module, so that the battery voltage simulation circuit is prevented from experiencing excessively high or low supply currents, thereby improving the operational safety of personnel in operating the battery voltage simulation circuit.

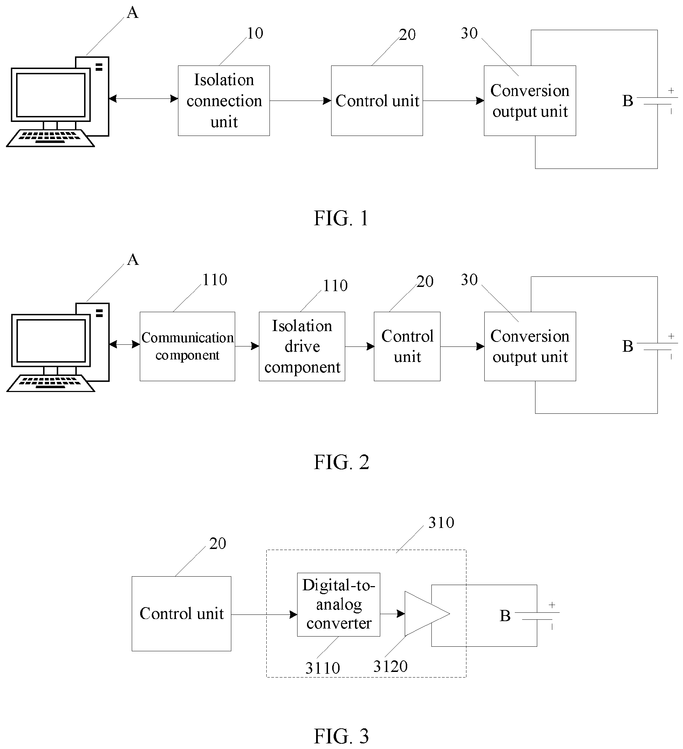

Based on the above concept, the present application first provides a battery voltage simulation circuit, as shown in FIG. 1, including an isolation connection unit 10, a control unit 20, and a conversion output unit 30. An input end of the isolation connection unit 10 is configured to be electrically connected to an external input device A, an output end of the isolation connection unit 10 is electrically connected to an input end of the control unit 20, an output end of the control unit 20 is electrically connected to an input end of the conversion output unit 30, and an output end of the conversion output unit 30 is configured to be electrically connected to a simulated battery cell B. The external input device A includes, but is not limited to, a computer, a server, or an upper-level computer, and the simulated battery cell B refers to a battery cell in which no electrolyte has been injected.

In the battery voltage simulation circuit designed as described above, the isolation connection unit 10 can achieve electrical isolation between the external input device A and the control unit 20. Electrical isolation refers to a condition in which two or more electrical circuits in an electrical system are separated through physical or electrical means, so as to prevent current from directly flowing between them while still allowing transmission of signals or energy.

The isolation connection unit 10 can also receive a required voltage signal transmitted by the external input device A, where the required voltage signal can be input through user operation of the external input device A. The required voltage signal represents a digital signal indicating the voltage to be simulated by the simulated battery cell B, for example, a digital signal representing a voltage of 3V.

After receiving the required voltage signal transmitted by the external input device A, the isolation connection unit 10 can transmit the required voltage signal to the control unit 20. The control unit 20 responds to the required voltage signal and outputs a pulse modulation signal with a target duty cycle to the conversion output unit 30. The control unit 20 stores the association between different required voltage signals and corresponding duty cycles, with different required voltage signals corresponding to different duty cycles of the pulse modulation signal. Upon receiving the required voltage signal, the control unit 20 can look up the target duty cycle corresponding to the required voltage signal and output the pulse modulation signal with the target duty cycle. As a possible implementation, the control unit 20 may include a register, where the mapping relationship between different required voltage signals and corresponding duty cycles can be stored. The control unit can obtain a target duty cycle corresponding to a required voltage signal by accessing and querying the register.

Specifically, in this solution, combinations of required voltages and duty cycles (for example, higher bits representing a required voltage and lower bits representing a corresponding duty cycle) can be pre-stored in binary code form in the register. The control unit 20 can find a combination in the register that is the same as the digital value of a required voltage signal based on the required voltage signal (digital signal), thereby obtaining the duty cycle from the lower bits of the combination, and thus the target duty cycle.

After the control unit 20 outputs the pulse modulation signal with the target duty cycle, the conversion output unit 30 can convert the pulse modulation signal with the target duty cycle into a corresponding voltage simulation signal, enabling the simulated battery cell B to simulate the output of the required voltage. Thus, in this solution, the simulated battery cell B can simulate the output of different voltages through the battery voltage simulation circuit via the external input device A, thereby enabling simulation of battery cell fault voltages and facilitating teaching experiments on energy-storage batteries.

In the battery voltage simulation circuit designed as described above, in this solution, the control unit stores the association between different required voltage signals and corresponding duty cycles. Thus, upon receiving different required voltage signals, the control unit can output a pulse modulation signal with a duty cycle corresponding to the required voltage based on the required voltage signal, so that after digital-to-analog conversion of the pulse modulation signal, the output of the simulated battery voltage output is implemented. Then, with the use of pulse modulation signals with different duty cycles, the adjustment of different simulated battery voltages can be implemented, enabling high-precision simulation and adjustment of battery voltage to meet application scenarios with high voltage precision requirements, such as teaching experiments. In addition, the design of the isolation connection unit in this solution effectively isolates the external input device from the control unit, preventing external interference from affecting the internal circuit, thereby improving the stability and reliability of the entire circuit system and reducing the possibility of voltage simulation errors and circuit failures due to external interference.

In an optional implementation of the embodiments, as shown in FIG. 2, the isolation connection unit 10 designed in this solution may include a communication component 110 and an isolation drive component 120. An input end of the communication component 110 is configured to be electrically connected to the external input device A, an output end of the communication component 110 is electrically connected to an input end of the isolation drive component 120, and an output end of the isolation drive component 120 is electrically connected to the control unit 20.

In the above implementation, the external input device A typically has interface ports. To enable connection and communication between the battery voltage simulation circuit designed in this solution and the external input device A, the communication component 110 is used to connect with the external input device A to achieve communication data transmission in this solution. For example, if the external input device A is a USB port, to overcome the issue of communication protocol incompatibility between the external device and the designed battery voltage simulation circuit, the communication component 110 designed in this solution may be a CAN module. The required voltage signal transmitted by the external input device A is first transmitted to the CAN module via the USB port and then forwarded to the isolation drive component 120 through the CAN module, thereby achieving interactive communication between the battery voltage simulation circuit and the external input device A. The CAN (Controller Area Network) module, namely a controller local area network module, is an electronic module used for communication between devices. In this solution, any existing CAN module may be adopted. In addition to adopting a CAN module for communication and connection, other forms of communication components may also be adopted in this solution, such as a wireless communication module or a Bluetooth module.

After receiving the required voltage signal transmitted by the communication component 110, the isolation drive component 120 can forward the required voltage signal to the control unit and electrically isolate the control unit 20 from the external input device A. Specifically, the signals processed by the control unit 20 in this solution are typically low-voltage, low-current digital signals, while the signals transmitted by the external input device A are higher voltage and larger current signals. Therefore, the required voltage signal transmitted by the external input device A needs to be electrically isolated through the isolation drive component 120, then attenuated and converted into a digital signal suitable for the control unit 20, thereby enabling effective driving of the control unit 20.

Specifically, as a possible implementation, the isolation drive component 120 may adopt an isolation drive chip, specifically any of various existing signal isolation drive chips, such as ISO1050 or SIT1050. These isolation drive chips adopt intelligent voltage division technology (iDivider) and sophisticated standard semiconductor CMOS processes, significantly improving device performance with clear advantages in power consumption, transmission rate, anti-interference capability, and the like. Using the principle of capacitive voltage division, signals are transmitted directly through the isolation medium without the need for modulation and demodulation. In this solution, any existing isolation drive chip based on actual application scenarios may be adopted.

With the above implementation, the design of the isolation connection unit effectively isolates the external input device from the control unit, preventing external interference from affecting the internal circuit, thereby improving the stability and reliability of the entire circuit system and reducing the possibility of voltage simulation errors and circuit failures due to external interference.

In an optional implementation of the embodiments, as shown in FIG. 3, the conversion output unit 30 may specifically include at least one digital-to-analog conversion group 310, where each digital-to-analog conversion group 310 includes one digital-to-analog converter 3110 and one operational amplifier 3120. An input end of the digital-to-analog converter 3110 of each digital-to-analog conversion group 310 is electrically connected to the output end of the control unit 20, an output end of the digital-to-analog converter 3110 of each digital-to-analog conversion group 310 is connected to an input end of the operational amplifier 3120 of the corresponding digital-to-analog conversion group 310, and an output end of each operational amplifier 3120 is configured to be electrically connected to one simulated battery cell B.

In the above implementation, the digital-to-analog converter is a component that converts digital signals into analog signals. In the present application, the digital-to-analog converter 3110 can convert the pulse modulation signal (digital signal) with the target duty cycle transmitted by the control unit 20 into a corresponding voltage simulation signal and transmit it to the corresponding connected operational amplifier 3120. The operational amplifier 3120 amplifies and outputs the voltage simulation signal, enabling the simulated battery cell B connected to the operational amplifier 3120 to simulate the output of the required voltage.

As a possible implementation, one digital-to-analog conversion groups 310 may be provided, as shown in FIG. 3. In this case, the control unit 20 designed in this solution may be connected to one simulated battery cell B through one digital-to-analog converter 3110 and one operational amplifier 3120, thereby allowing the control unit 20 to control the voltage simulation of a single simulated battery cell B.

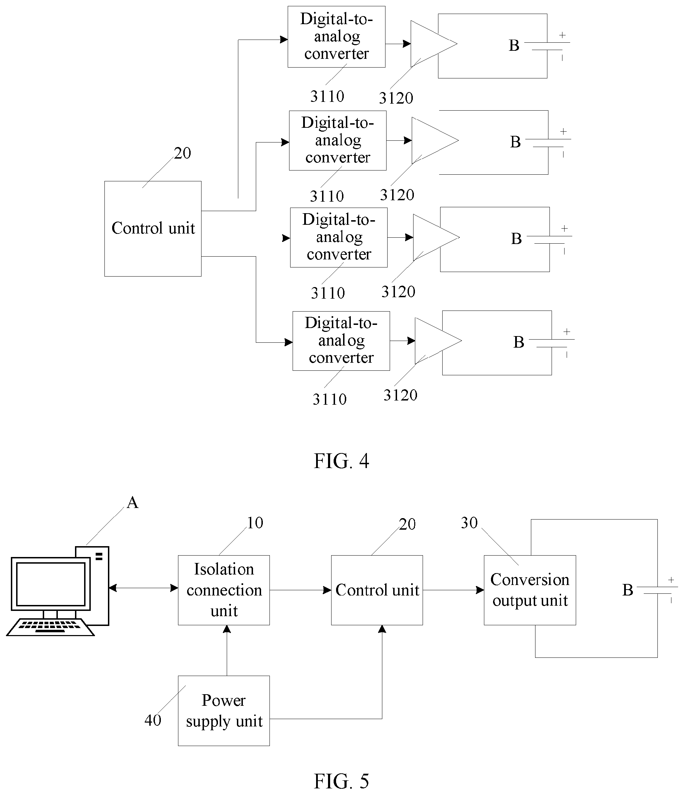

As another possible implementation, as shown in FIG. 4, multiple digital-to-analog conversion groups 310 designed in this solution may be provided (for example, four as shown in FIG. 4). In this case, the control unit 20 designed in this solution may be connected to four digital-to-analog conversion groups 310 simultaneously, enabling the control unit 20 to simulate and adjust the voltage of four simulated battery cells B at once.

With the above implementation, the control unit designed in this solution can connect to multiple digital-to-analog conversion groups simultaneously, enabling the control unit to simulate and adjust voltages of multiple simulated battery cells at once. Consequently, under the condition of performing voltage simulation for multiple simulated battery cells, the arrangement space of components is reduced, thereby saving component resources and costs.

In an optional implementation of the embodiments, the control unit 20 designed in this solution may specifically be a microcontroller, a central processing unit (CPU), or the like, with the specific component type and model adjustable based on actual application scenarios. For example, a 32-bit microcontroller may be adopted in this solution, such as STM32F103 or CS32F103.

In an optional implementation of the embodiments, as shown in FIG. 5, the battery voltage simulation circuit designed in this solution further includes a power supply unit 40. The power supply unit 40 is electrically connected to the isolation connection unit 10 and the control unit 20, respectively, to supply power to the isolation connection unit 10 and the control unit 20.

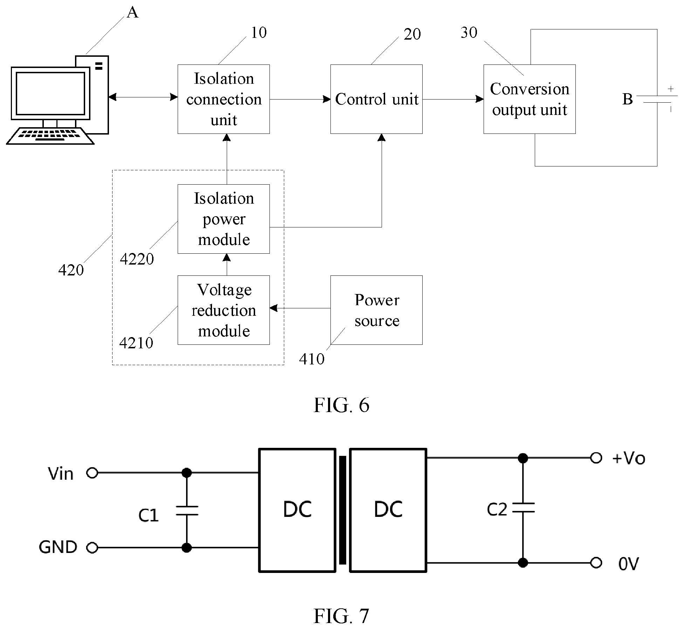

As a possible implementation, since the supply voltage of the power source generally does not match the rated operating voltages of the isolation connection unit 10 and the control unit 20, as shown in FIG. 6, the power supply unit 40 designed in this solution may include a power source 410 and a voltage reduction component 420. The power source 410 is electrically connected to the isolation connection unit 10 and the control unit 20, respectively, through the voltage reduction component 420.

With the above implementation, since the rated operating voltages of the isolation connection unit 10 and the control unit 20 are generally different, the voltage reduction component 420 designed in this solution can reduce a supply voltage of the power source to a first supply voltage and a second supply voltage, where the first supply voltage is used to supply power to the isolation connection unit 10, and the second supply voltage is used to supply power to the control unit 20.

For example, the rated operating voltage of the isolation connection unit 10 is 5 V and the rated operating voltage of the control unit 20 is 3.3 V, while the supply voltage of the power source 410 is 12 V. In this case, the voltage reduction component 420 reduces the supply voltage of the power source to 5 V and 3.3 V, where 5 V is used to supply power to the isolation connection unit 10, and 3.3 V is used to supply power to the control unit 20.

Specifically, as a possible implementation, when the isolation connection unit 10 includes a CAN module and an isolation drive chip, the voltage reduction component 420 in this solution may adopt the first supply voltage to supply power to both the CAN module and the isolation drive chip simultaneously.

In an optional implementation of the embodiments, continuing to refer to FIG. 6, the voltage reduction component 420 designed in this solution may specifically include a voltage reduction module 4210 and an isolation power module 4220. An input end of the voltage reduction module 4210 is electrically connected to the power source 410, and an output end of the voltage reduction module 4210 is electrically connected to the isolation connection unit 10 and the control unit 20 through the isolation power module 4220.

With the above implementation, the voltage reduction module 4210 reduces the supply voltage of the power source to the first supply voltage and the second supply voltage, then transmits the first supply voltage to the isolation connection unit 10 through the isolation power module 4220 and transmits the second supply voltage to the control unit 20 through the isolation power module 4220, thereby achieving electrical isolation between the isolation connection unit 10, the control unit 20, and the power source 410.

The isolation power module 4220 can separate its input and output to protect downstream load devices and systems, eliminating ground loops between isolation circuits, cutting off the propagation paths of interference signals such as common-mode and surge signals, effectively reducing the impact of ground potential differences and wire coupling interference, and improving common-mode interference suppression and anti-interference capabilities. The isolation power module 4220 designed in this solution, as shown in FIG. 7, adopts an international standard SIP package, complies with ROHS directives, and has advantages such as small size, high power density, low output ripple noise, good thermal stability, and strong temperature characteristics. To further reduce input and output ripple, a capacitor filter network is connected at both the input and output ends. The isolation voltage of the isolation power may reach up to 1000 V DC, with an insulation resistance of up to 1000 MΩ, enabling the designed battery voltage simulation circuit to meet insulation detection withstand voltage requirements and thereby improving the operational safety for personnel.

In addition, the voltage reduction module 4210 adopted in this solution may adopt any existing form of voltage reduction circuit, such as a capacitor voltage reduction circuit, a resistor voltage reduction circuit, an inductor voltage reduction circuit, or a voltage reduction chip circuit. Specifically, for example, in this solution, a first linear regulator chip AMS1117-5.0 may be used to first reduce the 12 V voltage of the power source to a first supply voltage of 5 V, and the first supply voltage of 5 V is adopted to supply power to the isolation connection unit 10, then a second linear regulator chip AMS1117-5.0 is adopted to reduce and regulate the first supply voltage of 5 V to a second supply voltage of 3.3 V, and the second supply voltage of 3.3 V is used to supply power to the control unit 20.

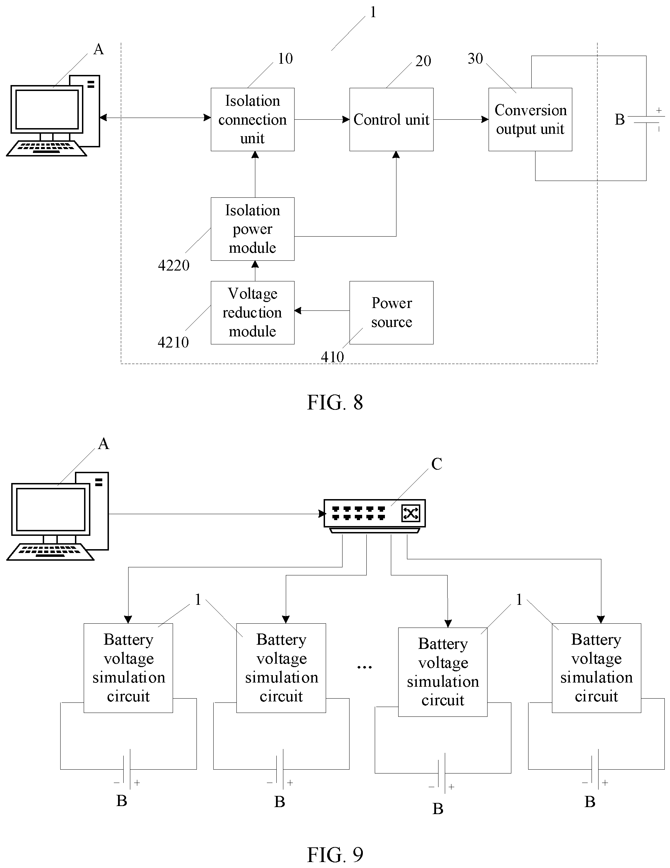

The present application also provides a battery voltage simulation system, as shown in FIG. 8, including the battery voltage simulation circuit 1 described in any of the above implementations, an external input device A, and a simulated battery cell B, where an input end of the isolation connection unit 10 is electrically connected to the external input device A, and the conversion output unit 30 is electrically connected to the simulated battery cell B.

The battery voltage simulation system designed as described above includes the battery voltage simulation circuit described above. Therefore, the designed battery voltage simulation system can store the association between different required voltage signals and corresponding duty cycles in the control unit. Thus, upon receiving different required voltage signals, the control unit can output a pulse modulation signal with a duty cycle corresponding to the required voltage based on the required voltage signal, so that after digital-to-analog conversion of the pulse modulation signal, the output of the simulated battery voltage output is implemented. Then, with the use of pulse modulation signals with different duty cycles, the adjustment of different simulated battery voltages can be implemented, enabling high-precision simulation and adjustment of battery voltage to meet application scenarios with high voltage precision requirements, such as teaching experiments. In addition, the design of the isolation connection unit in this solution effectively isolates the external input device from the control unit, preventing external interference from affecting the internal circuit, thereby improving the stability and reliability of the entire circuit system and reducing the possibility of voltage simulation errors and circuit failures due to external interference.

In an optional implementation of the embodiments, as a possible implementation, as shown in FIG. 9, the battery voltage simulation system designed in this solution may include multiple battery voltage simulation circuits 1, and the battery voltage simulation system may further include a communication bus C. On this basis, the external input device A is electrically connected to the isolation connection unit 10 of each battery voltage simulation circuit 1 through the communication bus C.

With the above implementation, the battery voltage simulation system designed in this solution connects multiple battery voltage simulation circuits through the communication bus, facilitating expansion of the number of simulated battery cells to meet the simulation needs of battery packs of different scales. The system can be applied to both small-scale laboratory tests and large-scale industrial development and research projects.

The present application also provides a power battery training apparatus, including the battery voltage simulation system described in any optional implementation of the above.

The power battery training apparatus designed as described above includes the battery voltage simulation system described above. Therefore, the designed power battery training apparatus can store the association between different required voltage signals and corresponding duty cycles in the control unit. Thus, upon receiving different required voltage signals, the control unit can output a pulse modulation signal with a duty cycle corresponding to the required voltage based on the required voltage signal, so that after digital-to-analog conversion of the pulse modulation signal, the output of the simulated battery voltage output is implemented. Then, with the use of pulse modulation signals with different duty cycles, the adjustment of different simulated battery voltages can be implemented, enabling high-precision simulation and adjustment of battery voltage to meet application scenarios with high voltage precision requirements, such as teaching experiments. In addition, the design of the isolation connection unit in this solution effectively isolates the external input device from the control unit, preventing external interference from affecting the internal circuit, thereby improving the stability and reliability of the entire circuit system and reducing the possibility of voltage simulation errors and circuit failures due to external interference.

Finally, it should be noted that the above embodiments are only used to illustrate the technical solutions of the present application, but not to limit them. Although the present application has been described in detail with reference to the foregoing embodiments, those of ordinary skill in the art should understand that the technical solutions recorded in the foregoing embodiments may still be modified, or some technical features thereof may be equivalently replaced; and these modifications or replacements do not make essence of a corresponding technical solution depart from the spirit and scope of the technical solutions of the embodiments of the present application. In particular, as long as there is no structural conflict, the various technical features mentioned in the embodiments can be combined in any manner. The present application is not limited to the specific embodiments disclosed herein but includes all technical solutions falling within the scope of the claims.

## Claims

1. A battery voltage simulation circuit, **characterized by** comprising: an isolation connection unit, a control unit, and a conversion output unit; wherein an input end of the isolation connection unit is configured to be electrically connected to an external input device, an output end of the isolation connection unit is electrically connected to an input end of the control unit, an output end of the control unit is electrically connected to an input end of the conversion output unit, and an output end of the conversion output unit is configured to be electrically connected to a simulated battery cell;
the isolation connection unit is configured to electrically isolate the control unit from the external input device, receive a required voltage signal transmitted by the external input device, and transmit the required voltage signal to the control unit;
the control unit is configured to respond to the required voltage signal by outputting a pulse modulation signal with a target duty cycle to the conversion output unit, wherein pulse modulation signals corresponding to different required voltage signals have different duty cycles; and
the conversion output unit is configured to convert the pulse modulation signal with the target duty cycle into a corresponding voltage simulation signal, enabling the simulated battery cell to simulate the output of the required voltage.

2. The battery voltage simulation circuit according to claim 1, **characterized in that** the isolation connection unit comprises a communication component and an isolation drive component; wherein an input end of the communication component is configured to be electrically connected to the external input device, an output end of the communication component is electrically connected to an input end of the isolation drive component, and an output end of the isolation drive component is electrically connected to the control unit;
the communication component is configured to forward the required voltage signal transmitted by the external input device to the isolation drive component; and
the isolation drive component is configured to electrically isolate the control unit from the external input device and transmit the required voltage signal to the control unit.

3. The battery voltage simulation circuit according to claim 1, **characterized in that** the conversion output unit comprises at least one digital-to-analog conversion group, wherein each digital-to-analog conversion group comprises one digital-to-analog converter and one operational amplifier, an input end of the digital-to-analog converter of each digital-to-analog conversion group is electrically connected to the output end of the control unit, an output end of the digital-to-analog converter of each digital-to-analog conversion group is connected to an input end of the operational amplifier of the corresponding digital-to-analog conversion group, and an output end of each operational amplifier is configured to be electrically connected to one simulated battery cell;
the digital-to-analog converter is configured to convert the pulse modulation signal with the target duty cycle into a corresponding voltage simulation signal and transmit it to the operational amplifier; and
the operational amplifier is configured to amplify the voltage simulation signal and output it, enabling the corresponding connected simulated battery cell to output the required voltage.

4. The battery voltage simulation circuit according to claim 3, **characterized in that** one or more digital-to-analog conversion groups are provided.

5. The battery voltage simulation circuit according to claim 1, **characterized in that** the battery voltage simulation circuit further comprises a power supply unit; wherein the power supply unit is electrically connected to the isolation connection unit and the control unit, respectively, to supply power to the isolation connection unit and the control unit.

6. The battery voltage simulation circuit according to claim 5, **characterized in that** the power supply unit comprises a power source and a voltage reduction component; wherein the power source is electrically connected to the isolation connection unit and the control unit through the voltage reduction component; and
the voltage reduction component is configured to reduce a supply voltage of the power source to a first supply voltage and a second supply voltage; wherein the first supply voltage is used to supply power to the isolation connection unit, and the second supply voltage is used to supply power to the control unit.

7. The battery voltage simulation circuit according to claim 6, **characterized in that** the voltage reduction component comprises a voltage reduction module and an isolation power module; wherein an input end of the voltage reduction module is electrically connected to the power source, and an output end of the voltage reduction module is electrically connected to the isolation connection unit and the control unit through the isolation power module;
the voltage reduction module is configured to reduce the supply voltage of the power source to the first supply voltage and the second supply voltage and transmit the first supply voltage and the second supply voltage to the isolation power module; and
the isolation power module is configured to transmit the first supply voltage to the isolation connection unit, transmit the second supply voltage to the control unit, and electrically isolate the isolation connection unit and the control unit from the power source.

8. A battery voltage simulation system, **characterized in that** the battery voltage simulation system comprises the battery voltage simulation circuit according to any one of claims 1 to 7, an external input device, and a simulated battery cell; wherein an input end of the isolation connection unit is electrically connected to the external input device, and the conversion output unit is electrically connected to the simulated battery cell.

9. The battery voltage simulation system according to claim 8, **characterized in that** multiple battery voltage simulation circuits are provided, the battery voltage simulation system further comprises a communication bus, and the external input device is electrically connected to the isolation connection unit of each battery voltage simulation circuit through the communication bus.

10. A power battery training apparatus, **characterized in that** the power battery training apparatus comprises the battery voltage simulation system according to any one of claims 8 or 9.
